(19) Europäisches Patentamt
European Patent Office
Office européen des brevets

(11) EP 2 645 557 A1

(12) EUROPEAN PATENT APPLICATION

(43) Date of publication:
02.10.2013 Bulletin 2013/40

(51) Int Cl.:
H02M 3/338 (2006.01)          B60L 11/18 (2006.01)
H02J 7/00 (2006.01)

(21) Application number: 12305380.3

(22) Date of filing: 30.03.2012

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: EH Europe GmbH
8001 Zürich (CH)

(72) Inventors:
• Kechmire, Mohamed
  62033 Arras cedex (FR)

• Beaucamp, François
  62033 Arras cedex (FR)
• Letome, David
  62033 Arras cedex (FR)

(74) Representative: Williams, Rhys Nicholas
Abel & Imray
20 Red Lion Street
London WC1R 4PQ (GB)

(54) **Method of calculating the input current drawn by a power converter**

(57)     The invention relates to a method and apparatus for calculating the input current being drawn by a power converter. The power converter may be connected to and charging a battery and the method includes the steps of measuring the current and voltage being supplied to the battery, along with the frequency at which the power converter is operating. The voltage being supplied to the power converter may be calculated using a pre-determined relationship with the current and voltage being supplied to the power converter and the frequency of operation. The voltage being supplied to the converter may then be used to calculate the current being drawn by the converter.

FIG. 1

**Description**

Field of the Invention

The present invention concerns a power converter. More particularly, but not exclusively, this invention concerns a battery charger comprising a power converter and a method of operation thereof.

Background of the Invention

Industrial users of large batteries, for example, forklift truck batteries, require charging facilities to recharge the batteries once they have been depleted through use. The depleted batteries are connected to battery chargers, which are in turn connected to a mains electricity supply to provide the necessary electrical energy to recharge the batteries. Typically the mains electricity supply to the battery charging unit is alternating current, which is converted by a power converter in the battery charging unit, and a direct current is supplied to the battery for recharging. Depending on the individual battery being charged, there may be an optimum charging profile in which the voltage and current supplied to the battery varies over time.

Power supply companies may limit the maximum current that an industrial user may draw from the mains electricity supply network. This may be in order to balance the load on the mains electricity supply network, so that the power taken by the industrial user does not cause supply problems, for example, brownout or blackout, for other users. There may be financial penalties for users that exceed their maximum current limit.

In order that a battery may be charged using the optimum charging profile, the voltage and current supplied to the battery may be monitored. The battery charger may then adjust the level of current it is drawing from the mains supply in order to achieve the desired charging profile. However, due to losses in the charger, in order to obtain the necessary power output, the power input into the charger must be greater than the required output. This may result in the charger attempting to draw a larger current than allowed by the electricity supplier.

The user may attempt to avoid exceeding the maximum current allowance by monitoring the current drawn by the charging unit. However, it is both difficult and expensive to provide measuring units suitable for monitoring the large input current (and voltage) taken by the charging unit.

The present invention seeks to mitigate the above-mentioned problems.

Summary of the Invention

The invention provides, according to a first aspect, a method of calculating the input current being drawn by a power converter ($I_{mains}$), the power converter being connected to and charging a battery, the method comprising the steps of: measuring the voltage being supplied to the battery ($V_{bat}$) ; measuring the current being supplied to the battery ($I_{bat}$) ; measuring the frequency at which the power converter is operating ($f_{converter}$) ; calculating the voltage supplied to the power converter ($V_{mains}$) using a pre-determined relationship between $V_{bat}$, $I_{bat}$, and $f_{convertor}$, and $V_{mains}$; and using the value of $V_{mains}$ to calculate $I_{mains}$.

The method allows the current being drawn by the power converter ($I_{mains}$) to be calculated without requiring that the current is directly measured. The power converter may be regulated such that the current drawn does not exceed a maximum level. This may allow a user of the power converter to avoid fines for exceeding a maximum allowed current level. This may also protect the power system supplying the power converter by preventing excess power demands from the power converter.

The power converter may be part of a battery charging unit. The battery charging unit may comprise a plurality of power modules, each power module including a power converter.

The method may include the step of calculating the power output of the power convertor ($P_{out}$).

The method may include the step of calculating the power input into the power converter ($P_{in}$). $P_{in}$ may be calculated using the value of $P_{out}$ and the average efficiency of the power converter ($\eta$). The average efficiency of the power converter ($\eta$) may be determined by testing the power converter during the manufacturing and calibration stage. The power converter may be tested using 400V or 480V AC.

The tests may be undertaken from 10% load to 100% load of the power converter.

The step of calculating $I_{mains}$ may include using the power factor for the power converter. The power factor may be determined by testing the power converter during the manufacturing and calibration stage. The power converter may be tested using 400V or 480V AC. The tests may be undertaken from 10% load to 100% of the power converter.

The steps of measuring $V_{bat}$ and $I_{bat}$ may be undertaken by a measurement device associated with the battery. The measurement device may be arranged to communicate $V_{bat}$ and $I_{bat}$ wirelessly.

The calculation steps may be carried out by a control module associated with the power converter. The control module may be arranged to receive the measurements of $V_{bat}$ and $I_{bat}$ wirelessly.

Measuring $V_{bat}$ and $I_{bat}$ directly as supplied to the battery terminals and wirelessly communicating the measurements to the control module removes any current and/or voltage loss that would occur in battery cables.

A second aspect of the invention provides a battery charger, the battery charger comprising a master controller and a plurality of power modules, each power module comprising a power converter and being configured to draw electrical power from a mains power source and supply electrical power to a battery, wherein the master controller is arranged to determine the current being drawn by each of the power modules during a battery charging process as set out with regards to the method as described above.

A third aspect of the invention provides a method of charging a battery, comprising the steps of: connecting a battery to a battery charger, controlling the power supplied to the battery by the battery charger, wherein the power drawn by the battery charger is limited to a maximum level and the power supplied to the battery by the battery charger is controlled in dependence on this maximum level, and the power being drawn by the battery charger is predicted by monitoring the power being supplied to the battery.

It will of course be appreciated that features described in relation to one aspect of the present invention may be incorporated into other aspects of the present invention. For example, the method of the invention may incorporate any of the features described with reference to the apparatus of the invention and *vice versa*.

Description of the Drawings

Embodiments of the present invention will now be described by way of example only with reference to the accompanying schematic drawings of which:

Figure 1    shows a schematic representation of a battery charging unit according to a first embodiment of the invention;
Figure 2    shows a schematic representation of the connections between a master controller and power modules as shown in figure 1;
Figure 3    shows a schematic representation of a communications network between a battery charging unit as described with regards to figures 1 and 2, and a battery;
Figure 4    shows an algorithm used to determine the current and voltage levels supplied by a battery charging unit;
Figure 5    shows a schematic representing the regulation loops for a charging unit according to the invention;
Figure 6    shows a graphical representation of the values measured for output regulation of a charging unit;
Figure 7    sets out the algorithm used during the power output regulation of a charging unit;
Figure 8    is a graphical representation of the relationship between the frequency of the power converter and $V_{mains}$ at several output currents;
Figure 9    shows an algorithm used to calculate $I_{mains}$;
Figure 10    shows the load profile of a modular battery charger operating with three modules at full load; and
Figure 11    shows the load profile of a modular battery charger operating with three modules at full load and one module at 1% load.

Detailed Description

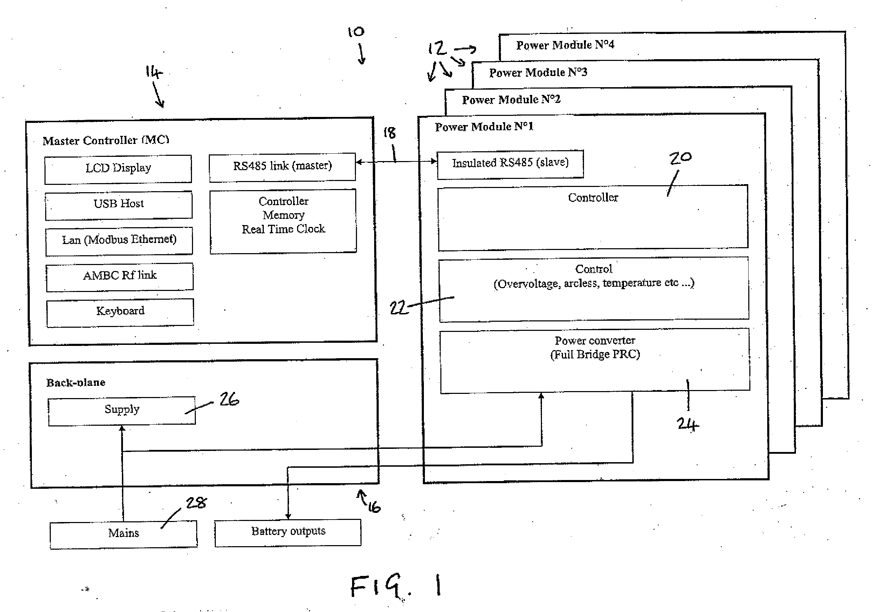

Figure 1 shows a modular battery charging unit 10, comprising a plurality of power modules 12, a master controller 14, and a back-plane 16. The master controller 14 is connected to each power module by an RS485 network, such that each power module 12 is a slave of the master controller 14. Each power module 12 comprises a controller 20, a monitor unit 22, and a power converter 24. In this case the power converter 24 is a full-bridge power resonant converter. In alternative embodiments the power converter may be any converter which uses the switching frequency to adjust power output. Examples of such converters include series resonant converters and parallel resonant converters. The back-plane 16 comprises a supply unit 26 configured for connection to the mains supply 28. Each of the power modules 12 is connected to the back-plane 16 such that the supply 26 is arranged to provide electricity to the power modules 12.

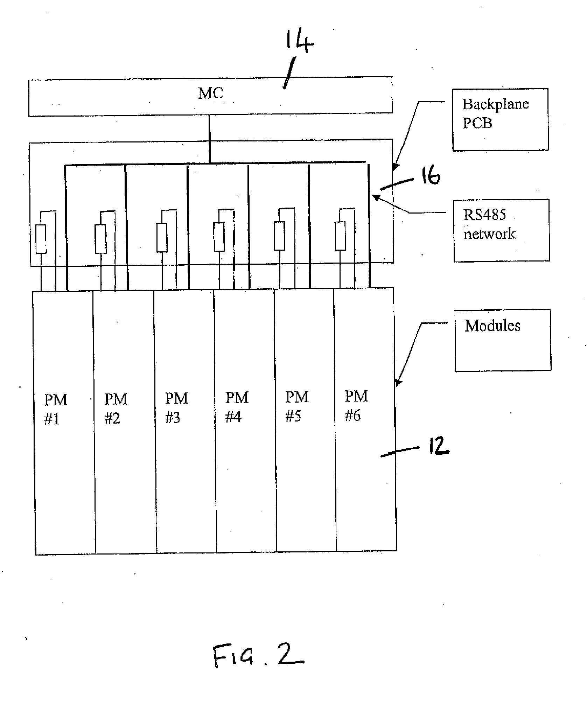

Figure 2 shows a schematic representation of connections between the master controller 14, the plurality of power modules 12 (in this case, six power modules), and the back-plane 16. The master controller exchanges digital data with the power modules 12 using a half-duplex RS485 network. Each of the power modules 12 and the master controller are insulated. The communications protocol used on the network is ModBus RTU. The back-plane is a printed circuit board (PCB) arranged such that each power module 12 is allocated an individual address by using a fixed resistor on the PCB, each power module 12 having a resistor of different value in order that the address is unique. The master controller 14 may read the following data from each power module: output voltage, output current, time elapsed since power module switched on, fault warnings, temperature (any or all of ambient temperature, semiconductor heat sink temperature, bus bar temperature). The master controller 14 may write the following data to each power module: requested output voltage, requested output current, requested current slope. Only two functions of the ModBus protocol are implemented in the master controller 14 and the power modules 12, namely: Function 3 (or 4) - read of data from the power modules 12 to the master controller 14, and Function 16 - write of data from the master controller 14 to the power modules 12. These read/write functions may be undertaken when a battery charging process is initiated. Each power module 12 is thereby a programmable voltage or current source, with all of the operational parameters being given by the master controller 14.

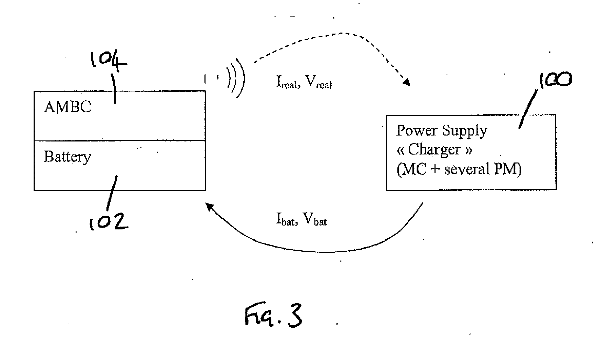

Figure 3 shows a schematic representation of a communications network between a battery charging unit 100 as described with regards to figures 1 and 2 and a battery 102 connected to the battery charging unit 100 for charging. The battery 102 includes a battery control device 104  arranged to detect several parameters of the battery, including: battery voltage, charging (or discharging) current, internal temperature of the battery, and water level if a flooded battery. The battery control device 104 includes a radio frequency transceiver arranged to be able to wirelessly communicate with the master controller of the charging unit 100. Such a battery control device could be the commercially available EnerSys WI-IQ device. The WI-IQ is available from EnerSys EMEA, EH Europe GmbH, Löwenstrasse 32, 8001 Zürich, Switzerland, and additional Enersys Motive Power Sales entities across the World. Providing the battery control device 104 with wireless communication is advantageous over a wired system as it allows voltage regulation without the influence of the length and section of the battery cables resulting in voltage losses in the readings. Instead, the voltage and current supplied to the battery 102 is measured directly at the terminals of the battery and then transmitted to the charging unit 100. As can be seen, the charging unit 100 supplies the battery 102 with a current $I_{bat}$ and a voltage $V_{bat}$ and the battery control device 104 detects the current and voltage and sends back the true readings of current ($I_{real}$) and voltage ($V_{real}$), which because the measurements are taken directly at the battery, correspond to $V_{bat}$ and $I_{bat}$.

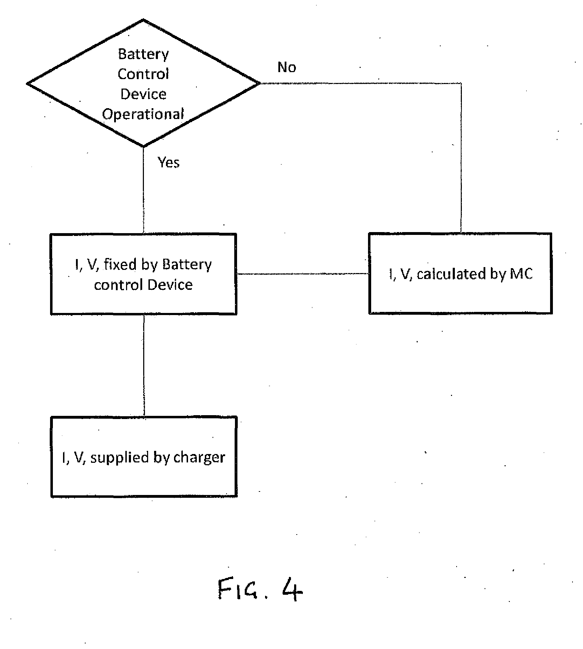

Figure 4 shows the algorithm the master controller 14 runs through when the charger 100 is first connected to a battery 102. Initially, the master controller 14 sends a signal to the battery control device 104. Assuming the battery control device 104 is installed on the battery 102 and is operating correctly, a return signal is sent to the master controller 14. If the battery control device 104 is operational, the current and voltage supplied to the battery  102 is set by the battery control device 104 and supplied to the battery 102 by the charger 100. If the master controller 14 fails to connect to a battery control device 104, the current and voltage supplied to the battery 102 is set by the master controller 14, and then supplied to the battery 102 by the charger 100.

If the master controller 14 fails to connect to a battery control device 104, the voltage supplied to the battery is calculated as follows. Voltage ($V_i$) and current ($I_i$) are measured at the output of each of the power modules 12, where there are n modules in the bank of modules. The cable resistance of the bank of modules connected to the battery is denoted by R. The value of R is calculated by testing the bank of modules during the set up of the apparatus. These values are digitally converted and transmitted to the master controller 14. For each bank of power modules 12 the current is summarised:

$$Global\ current\ delivered\ by\ system\text{:} I = \sum_{i=1}^{i=n} I_i$$

The reference voltage calculated by the master controller 14 is then calculated using:

$$Reference\ voltage\text{:}\ V_{out} = \frac{\sum_{i=1}^{i=n} V_i I_i}{\sum_{i=1}^{i=n} I_i}$$

The voltage supplied to the battery ($V_{bat}$) can then be calculated by:

$$V_{bat} = V_{out} - RI$$

The master controller 14 is arranged to regulate the output of the charger 100. In order to do this, the master controller is arranged to control the frequency of the power converters of each of the power modules that are being used.

The output power of the converter/converters is inversely proportional to the frequency of operation.

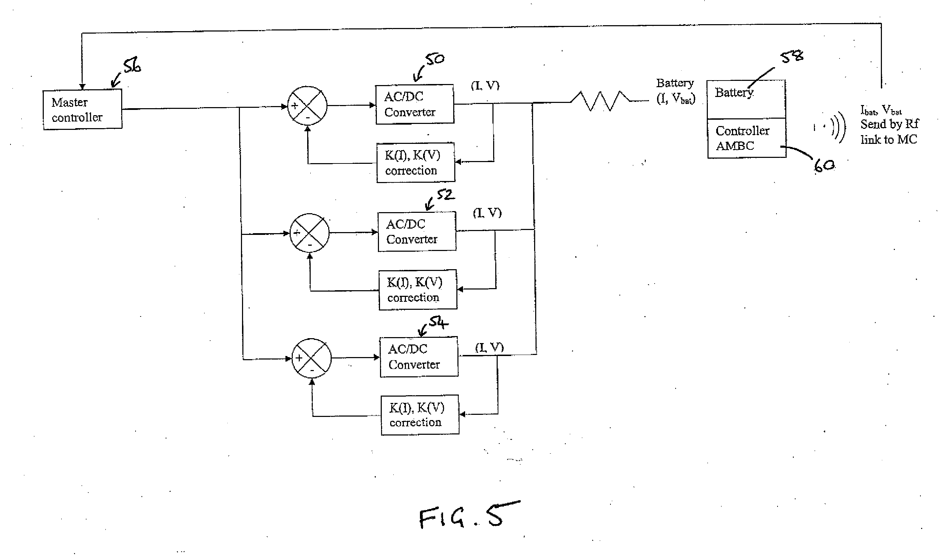

Figure 5 is a schematic showing the regulation loops used to regulate the output of the power modules and the master controller and power modules. In this embodiment, three power modules 50, 52, 54, are connected to a master controller 56. The power modules 50, 52, 54, are connected to a battery 58 such that they supply a current ($I_{bat}$) and voltage ($V_{bat}$) to the battery 58. A battery control device 60 is associated with the battery 58 and monitors the current ($I_{bat}$) and voltage ($V_{bat}$) supplied to the battery 58. The battery control device 60 wirelessly communicates these values back to the master controller 56. The battery control device 60 may also be arranged to determine the charge profile required by the battery 58 and monitor the temperature of the battery 58. As can be seen in figure 5, each of the power modules 50, 52, 54, includes a regulation loop in which the output current and voltage is monitored with corrective feedback provided if necessary. Further details are given below.

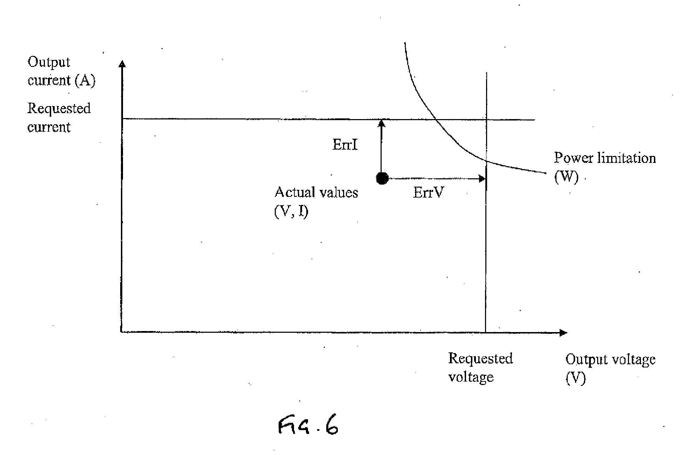

Figure 6 shows how the output of each module may be regulated. The output of each module is measured and the actual monitored values are indicated by (V,I) in figure 6. The requested current and voltage can be seen to be different and the difference between each of these values compared to the real, measured, values is represented by ErrI and ErrV. The measured values V and I may also be used to calculate any error between the actual output power and requested output power of the power module. The master controller 56 directly controls the frequency of operation of the converters of each power module, with the output power being inversely proportional to the frequency of operation. The level of regulation required by the power modules is proportional to the error between the requested output values and the real, measured, values that are output by the power module.

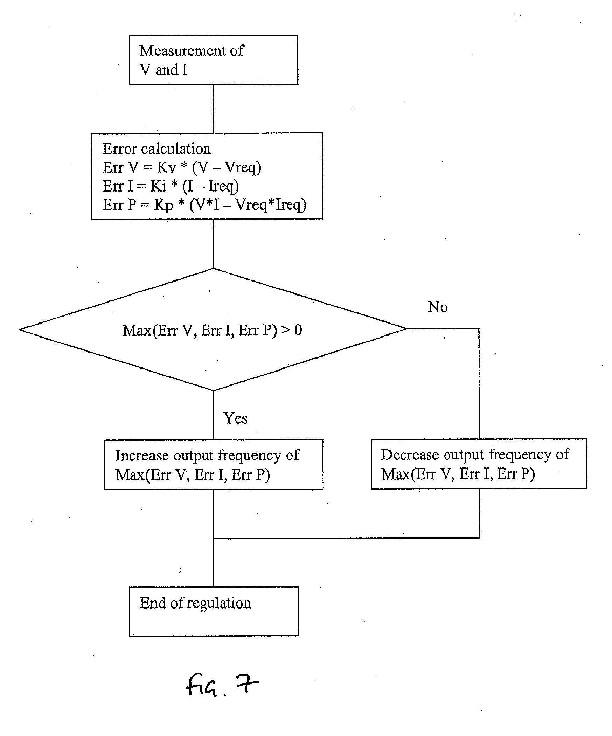

Figure 7 shows the algorithm that is used to calculate the error between the requested current, voltage, and power output and the measured current, voltage, and power output. The voltage and current output are measured and the error between the requested values and measured values calculated. If one or more of the three calculated errors is positive, the regulation loop increases the frequency of operation of the power module. If all of the calculated errors are negative, the regulation loop decreases the frequency of operation of the power module.

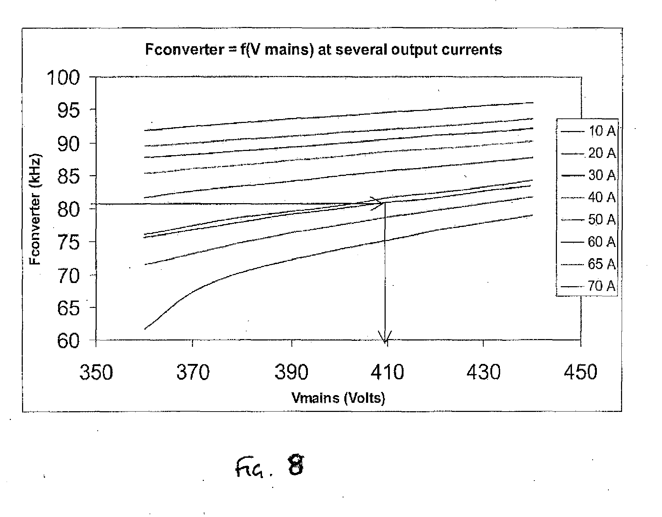

Figure 8 is a graph showing the relationship between converter frequency and mains input voltage, represented by a plurality of curves, each curve showing measurements taken at a different output current, from 10A to 70A. The graph indicates the relationship between the frequency of the converter ($F_{converter}$) to $V_{mains}$. These values are determined by testing the converter during the manufacture and calibration process and are stored in the master controller for use during operation of the converter. The testing of the power converter during the manufacture and calibration process is relatively routine and will be easily undertaken by the person skilled in the art, who will also appreciate that several testing routines may be used to determine the power converter characteristics. As such, the details of the testing and calibration procedure are not provided herein. Each power module is configured to operate such that the same output current is produced by the same frequencies, to an accuracy of $\pm 3\%$. The master controller may, from knowing the frequency of the converter and the current being output by the converter, calculate the corresponding mains voltage. In the example shown in figure 5, the measured output current is 62A and the frequency of the converter is 81kHz. The master controller calculated the curve for 62A as an extrapolation of the measured curves for 60A and 65A. On this curve it can be seen that for a frequency of 81kHz, the mains voltage will be 410V.

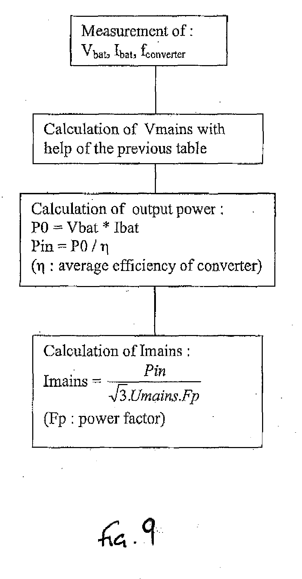

Figure 9 shows the algorithm that is used by the master controller 14 to calculate the mains current ($I_{mains}$) being drawn by the charger. As has been set out previously, the values of $V_{bat}$, $I_{bat}$, and $f_{converter}$ are measured. Using the graph and method shown and described with reference to figure 5, $V_{mains}$ is calculated. The power output of the charger $P_{out}$ is calculated as:

$$P_{out} = V_{bat} I_{bat}$$

The power input into the charger can be calculated by knowing the average efficiency of the power converters ($\eta$):

$$P_{in} = P_{out} \eta$$

As previously stated, the average efficiency of the power converters is calculated during the manufacture and calibration process. Finally, the main current may be calculated by knowing $P_{in}$, $V_{mains}$, and the power factor (Fp) of the power converters:

$$I_{mains} = \frac{P_{in}}{\sqrt{3V_{in}Fp}}$$

The power factor is calculated during the manufacture and calibration process. Using the calculated $I_{mains}$, the master controller may regulate the demands of the power modules on the mains supply such that the current drawn from the mains supply does not exceed a predetermined level. This will ensure that the user does not exceed the maximum current level that is set by the electricity supplier and so will not risk any penalty fees. It also protects the mains supply as excessive power demands will not be made by the battery charger.

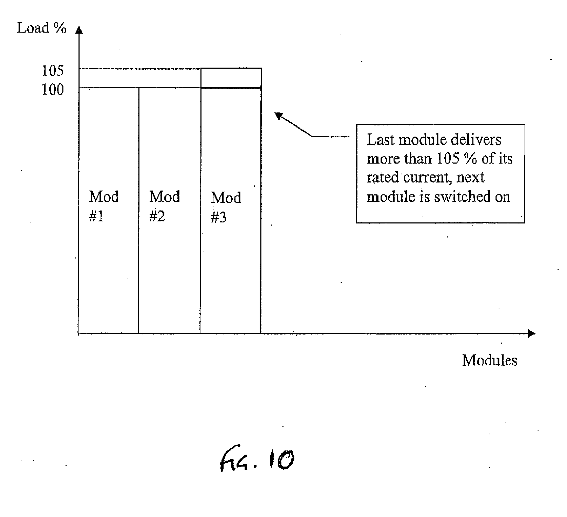

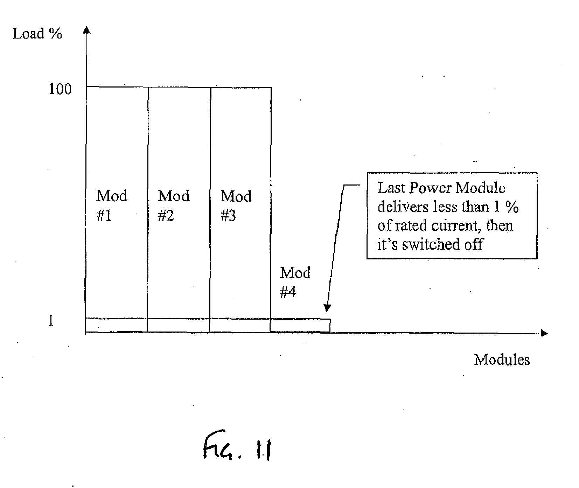

The power modules operate most efficiently at full load. Therefore, in order to most efficiently charge a battery, as many power modules as possible must be operated at full load. The supply to the battery is built up such that each of power modules is operated at full load, until 105% of full load is being demanded from that power module, at which point an additional power module is activated. This can be seen in figure 10 where the first two power modules are operating at 100% and the third power module is operating at 105%. This will trigger a fourth power module to be activated. When the load on a power module drops to less than 1% of the maximum load, the module is switched off. This can be seen in figure 11 where the fourth power module is operating at 1% and will be switched off as a result.

Whilst the present invention has been described and illustrated with reference to particular embodiments, it will be appreciated by those of ordinary skill in the art that the invention lends itself to many different variations not specifically illustrated herein. By way of example only, certain possible variations will now be described.

Additional embodiments of the invention may comprise any power supply using the switching frequency to adjust the output power. Example applications may be in the lighting industry, as applied to a telecommunications rectifier, or an uninterruptible power supply. Where in the foregoing description, integers or elements are mentioned which have known, obvious or foreseeable equivalents, then such equivalents are herein incorporated as if individually set forth. Reference should be made to the claims for determining the true scope of the present invention, which should be construed so as to encompass any such equivalents. It will also be appreciated by the reader that integers or features of the invention that are described as preferable, advantageous, convenient or the like are optional and do not limit the scope of the independent claims. Moreover, it is to be understood that such optional integers or features, whilst of possible benefit in some embodiments of the invention, may not be desirable, and may therefore be absent, in other embodiments.

**Claims**

1. A method of calculating the input current being drawn by a power converter ($I_{mains}$), the power converter being connected to and charging a battery, the method comprising the steps of:

   measuring the voltage being supplied to the battery ($V_{bat}$);
   measuring the current being supplied to the battery ($I_{bat}$);
   measuring the frequency at which the power converter is operating ($f_{converter}$) ;
   calculating the voltage supplied to the power converter ($V_{mains}$) using a pre-determined relationship between $V_{bat}$, $I_{bat}$, and $f_{converter}$, and $V_{mains}$; and
   using the value of $V_{mains}$ to calculate the $I_{mains}$.

2. A method as claimed in claim 1, including the step of calculating the power output of the power convertor (Pout).

3. A method as claimed in claim 1 or claim 2, including the step of calculating the power input into the power converter ($P_{in}$).

4. A method as claimed in claim 3, wherein $P_{in}$ is calculated using the value of $P_{out}$ and the average efficiency of the power converter ($\eta$).

5. A method as claimed in any preceding claim, wherein the step of calculating $I_{mains}$ includes using the power factor for the power converter.

6. A method as claimed in any preceding claim, wherein the steps of measuring $V_{bat}$ and $I_{bat}$ are undertaken by a measurement device associated with the battery.

7. A method as claimed in claim 6, wherein the measurement device is arranged to communicate $V_{bat}$ and $I_{bat}$ wirelessly.

8. A method as claimed in any preceding claim, wherein the calculation steps are carried out by a control module associated with the power converter.

9. A method as claimed in claim 8, wherein the control module is arranged to receive the measurements of $V_{bat}$ and $I_{bat}$ wirelessly.

10. A battery charger, the battery charger comprising a master controller and a plurality of power modules, each power module comprising a power converter and being configured to draw electrical power from a mains power source and supply electrical power to a battery, wherein the master controller is arranged to determine the current being drawn by the power modules during a battery charging process as set out with regards to the method as claimed in any of claim 1 to 9.

11. A method of charging a battery, comprising the steps of:

connecting a battery to a battery charger,
controlling the power supplied to the battery by the battery charger,
wherein the power drawn by the battery charger is limited to a maximum level and the power supplied to the battery by the battery charger is controlled in dependence on this maximum level, and the power being drawn by the battery charger is calculated by monitoring the power being supplied to the battery.

FIG. 1

Master Controller (MC) — 14

- LCD Display
- USB Host
- Lan (Modbus Ethernet)
- AMBC Rf link
- Keyboard
- RS485 link (master)
- Controller Memory Real Time Clock

Power Module N°4
Power Module N°3
Power Module N°2
Power Module N°1 — 12

- Insulated RS485 (slave)
- Controller — 20
- Control (Overvoltage, arcless, temperature etc ...) — 22
- Power converter (Full Bridge PRC) — 24

Back-plane

- Supply — 26

Mains — 28

Battery outputs — 16

10

18

EP 2 645 557 A1

FIG. 2

104

| AMBC |
|---|
| Battery |

102

$I_{real}$, $V_{real}$

100

| Power Supply<br>« Charger »<br>(MC + several PM) |
|---|

$I_{bat}$, $V_{bat}$

Fig. 3

FIG. 4

FIG. 5

Output
current (A)

Requested
current

EnI

Actual values
(V, I)

ErrV

Power limitation
(W)

Requested
voltage

Output voltage
(V)

Fig. 6

```
┌─────────────────────┐
│ Measurement of      │
│ V and I             │
└─────────────────────┘
          │
          │
┌───────────────────────────────┐
│ Error calculation             │
│ Err V = Kv * (V – Vreq)       │
│ Err I = Ki * (I – Ireq)       │
│ Err P = Kp * (V*I – Vreq*Ireq)│
└───────────────────────────────┘
          │
          │
        ◇◇◇◇◇◇◇◇◇◇◇◇◇◇◇◇◇◇◇◇◇◇◇◇◇◇◇◇◇◇◇                    No
      Max(Err V, Err I, Err P) > 0
        ◇◇◇◇◇◇◇◇◇◇◇◇◇◇◇◇◇◇◇◇◇◇◇◇◇◇◇◇◇◇◇
          │
         Yes
          │
┌───────────────────────────┐         ┌───────────────────────────┐
│ Increase output frequency │         │ Decrease output frequency │
│ of Max(Err V, Err I, Err P)│        │ of Max(Err V, Err I, Err P)│
└───────────────────────────┘         └───────────────────────────┘
          │                                    │
          └──────────────────┬─────────────────┘
                             │
                  ┌─────────────────────┐
                  │ End of regulation   │
                  └─────────────────────┘
```

fig. 7

Fig. 8

Measurement of :
$V_{bat}$, $I_{bat}$, $f_{converter}$

Calculation of Vmains with help of the previous table

Calculation of output power :
PO = Vbat * Ibat
Pin = PO / η
(η : average efficiency of converter)

Calculation of Imains :

$$Imains = \frac{Pin}{\sqrt{3}.Umains.Fp}$$

(Fp : power factor)

fig. 9

Load %

105
100

Mod #1 | Mod #2 | Mod #3

Last module delivers more than 105 % of its rated current, next module is switched on

Modules

FIG. 10

FIG. 11

Europäisches
Patentamt

European
Patent Office

Office européen
des brevets

# EUROPEAN SEARCH REPORT

**Application Number**

EP 12 30 5380

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2009/306914 A1 (COHEN ISAAC [US]) 10 December 2009 (2009-12-10) * paragraph [0022] - paragraph [0031]; figures 2,4 * ----- | 1-10 | INV. H02M3/338 B60L11/18 H02J7/00 |
| Y | EP 1 137 157 A2 (SONY CORP [JP]) 26 September 2001 (2001-09-26) * paragraph [0052]; figure 14 * ----- | 1-5 | |
| X | US 5 803 215 A (HENZE CHRISTOPHER P [US] ET AL) 8 September 1998 (1998-09-08) | 11 | |
| Y | * column 4, line 41 - column 6, line 10; figures 1, 2 * ----- | 6-10 | |
| | | | **TECHNICAL FIELDS SEARCHED (IPC)** |
| | | | H02M B60L H02J |

The present search report has been drawn up for all claims

| Place of search | Date of completion of the search | Examiner |
|---|---|---|
| Munich | 10 August 2012 | Kruip, Stephan |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 2 645 557 A1**

## ANNEX TO THE EUROPEAN SEARCH REPORT
## ON EUROPEAN PATENT APPLICATION NO.

EP 12 30 5380

This annex lists the patent family members relating to the patent documents cited in the above-mentioned European search report.
The members are as contained in the European Patent Office EDP file on
The European Patent Office is in no way liable for these particulars which are merely given for the purpose of information.

10-08-2012

| Patent document cited in search report | | Publication date | Patent family member(s) | | Publication date |
|---|---|---|---|---|---|
| US 2009306914 | A1 | 10-12-2009 | NONE | | |
| EP 1137157 | A2 | 26-09-2001 | CN | 1318896 A | 24-10-2001 |
| | | | EP | 1137157 A2 | 26-09-2001 |
| | | | JP | 2001275351 A | 05-10-2001 |
| | | | KR | 20010090539 A | 18-10-2001 |
| | | | TW | 506184 B | 11-10-2002 |
| | | | US | 2001036092 A1 | 01-11-2001 |
| US 5803215 | A | 08-09-1998 | US | 5803215 A | 08-09-1998 |
| | | | WO | 9832209 A1 | 23-07-1998 |

EPO FORM P0459

For more details about this annex : see Official Journal of the European Patent Office, No. 12/82